# EUROPEAN PATENT SPECIFICATION

(11) **EP 1 984 749 B1**
(45) Date of publication and mention of the grant of the patent: **29.06.2011**
(21) Application number: 06842679.0
(22) Date of filing: 22.12.2006
(51) Int. Cl.: G01R 31/12

(54) **METHOD AND APPARATUS FOR EVALUATING THE LEVEL OF SUPERFICIAL POLLUTION OF A MEDIUM/HIGH VOLTAGE OUTDOOR INSULATOR**
VERFAHREN UND VORRICHTUNG ZUR EVALUIERUNG DES GRADES OBERFLÄCHLICHER VERUNREINIGUNG EINES MITTEL-/HOCHSPANNUNGS-FREILUFTISOLATORS
PROCÉDÉ ET APPAREIL POUR EVALUER LE NIVEAU DE POLLUTION SUPERFICIELLE D'UN ISOLATEUR EXTERNE DE MOYENNE OU HAUTE TENSION

(30) Priority: 17.02.2006 IT PR20060012
(43) Date of publication of application: 29.10.2008
(73) Proprietor: TECHIMP TECHNOLOGIES S.r.l., 40121 Bologna (IT)
(72) Inventor: MONTANARI, Gian Carlo, I-40033 Casalecchio Di Reno (bologna) (IT); CAVALLINI, Andrea, I-40018 San Pietro In Casale (bologna) (IT); PULETTI, Francesco, I-06012 Citta' Di Castello (perugia) (IT)
(74) Representative: Conti, Marco
(86) International application number: PCT/IB2006/055028
(87) International publication number: WO 2007/093861

(56) References cited:
- US-A1- 2005 231 210
- US-B1- 6 192 317

## Description

### TECHNICAL FIELD AND BACKGROUND ART.

The present invention relates to a method for evaluating the level of superficial pollution of a medium/high voltage outdoor insulator.

The present invention further relates to an apparatus for evaluating the level of superficial pollution of a medium/high voltage outdoor insulator, provided with at least one sensor able to be operatively associated to the insulator to detect an electrical signal.

Within the field of medium / high voltage electrical systems (i.e. operating at voltage values varying from a few kV to hundreds of kV), it is fundamentally important to use insulators (often constituted, in turn, by chains of insulators arranged in series), to connect objects that are operatively at different values of potential. In particular, within the field of overhead lines for the transmission of medium/high voltage electrical energy, insulators are used for the suspension in air of conductors suitable for transmitting electrical energy, i.e. to connect the conductors to the trestles that support the conductors themselves.

Said insulators serve a crucial role with respect to the reliability of the electrical system in which they are placed, because their failure entails the out of service condition of the system or of a part thereof and constitutes a potential hazard for persons.

In this light, in the operation of said electrical system and in particular in maintenance activities, considerable efforts are being expended to provide ever more effective and active diagnostic techniques, although the effective application of such techniques entails numerous difficulties.

In particular, with regard to outdoors insulators, the main cause of failure is the superficial pollution of the insulators themselves, especially when they are installed in a saline environment. Superficial pollution is associated to the formation of conductive deposits, which promote the development of electrical discharges on the outer surface of the insulators. As long as said discharges involve a limited portion of the surface of an insulator, without short circuiting its electrodes (in this case, they are called partial discharges), they do not entail the immediate failure of the system. On the contrary, when a discharge short circuits the electrodes of the insulator (in this case, it is called flashover), it entails the failure of the system. Therefore, one can generally state that when an outdoors insulator is clean or has a low level of superficial pollution, the probability that it may fail is minimal; when instead an outdoors insulator has a high level of superficial pollution, the probability that it may fail is considerable.

In this light, different diagnostic techniques have been developed, to evaluate the level of superficial pollution of an insulator.

According to a first type of diagnostic techniques, the dusts deposited on the surface of the insulator to be examined are collected and evaluated, to determine a value of superficial conductivity of the insulator. This type of techniques is not suitable to conduct continuous monitoring, but enables at most to obtain pollution maps. Moreover, the reliability of such techniques is limited by the fact that pollution is often due to different climatic conditions, which entails the presence, in the collected dusts, of components having different degrees of conductivity and solubility.

According to another technique, optical measurements are taken, with the aim of evaluating the thickness of the layer of pollutant on the basis of the colour of a sample insulator. This technique, in addition to being quite costly, has limited effectiveness, because the thickness of the polluting layer on the surface of an insulator is not a reliable indicator of the dangerousness of the pollution of the insulator as a whole. According to yet another type of diagnostic techniques, the superficial dispersion current of a sample insulator positioned in predetermined climatic conditions is evaluated. Such techniques have an important limitation: they cannot be applied easily to operating insulators, but only to insulators present in the laboratory or in particular points of the transmission grids, e.g. inside substations. Said techniques require the application of a known voltage to an insulator and the measurement of the corresponding superficial dispersion current. The insulator must also be taken to predetermined climatic conditions (e.g., cooling it indoors and causing the condensation of the water vapour from the surrounding water).

Another known technique is to measure the specific failure voltage (also known as flashover voltage) of a type of insulators. This method has the disadvantage of being destructive, hence unusable for monitoring operating insulators.

According to a further diagnostic technique for insulators, the dispersion current (also called leakage current) is measured, i.e. the low frequency current that flows at the ends of the insulator and closes at ground. The method has low costs, but its reliability is limited, because its results are heavily influenced by environmental factors, e.g. humidity. **In this light,** US 2005/231210 **discloses a system for testing polymer insulators, based on the detection of a leakage current across the insulator.**

Thus, prior art techniques for diagnosing the level of superficial pollution of an outdoors insulator have various drawbacks and limitations, depending on the case. Moreover, such techniques share an additional limitation, associated to the fact that they evaluate quantities that are linked in substantially direct fashion to superficial pollution, which, however, is not the ultimate / direct cause of the failure. An insulator fails when there is an electrical discharge between the electrodes of the insulator itself.

This circumstance is certainly linked to the superficial pollution of the insulator, but indirectly, because, for equal levels of superficial pollution, the likelihood of failure depends also on the type of the insulator and on the environmental conditions.

It should also be noted that, especially within the field of scientific research, numerous technical solutions have been developed for measuring and evaluating an activity of partial discharges in an electrical apparatus for high voltages **(for example document** US-B1-6 192 317 **discloses methods for analyzing statistically a PD measurements in a high voltage insulation)**. However, said solutions have been developed and used to evaluate the possible presence of faults/defects (e.g. cavities, cracks, inclusions) in the dielectrics included in the insulating system, and to try to determine the dangerousness of the faults/defects. The application of such known techniques for measuring partial discharges at an outdoors insulator would not enable to solve the problem in question, i.e. evaluating the level of superficial pollution of the insulator itself. Such an application would enable at most to conduct a study on the ageing / degradation dynamics of the insulating material constituting the insulator. In this light, the use is known of measurements of partial discharges, conducted in a laboratory in a controlled environment, on insulators to study their intrinsic properties, i.e. the ability to withstand electrical stresses.

### DISCLOSURE OF INVENTION.

An object of the present invention is to eliminate the aforesaid drawbacks and to make available a method for evaluating the level of superficial pollution of an insulator, that is not destructive, but is effective and applicable to operating insulators.

Said objects are fully achieved by the method of the present invention, which is characterised by the content of the claims set out below and in particular in that it comprises a step of measuring an activity of partial discharges on an outer surface of the insulator, to derive an indicator of the level of superficial pollution of the insulator.

Another object of the present invention is to make available a diagnostic apparatus for evaluating the level of superficial pollution of a medium / high voltage outdoor insulator, that allows to operate in an effective and non destructive manner, in order to plan maintenance interventions on the insulator itself.

Said object is fully achieved by the apparatus of the present invention, which is characterised by the content of the claims set out below and in particular in that it comprises, in combination:
- means for acquiring a set of data relating to partial discharges on an outer surface of the insulator, said acquisition means receiving said electrical signal at their input;
- means for processing the acquired data, said processing providing an indicator of the level of superficial pollution of the insulator.

### BRIEF DESCRIPTION OF DRAWINGS.

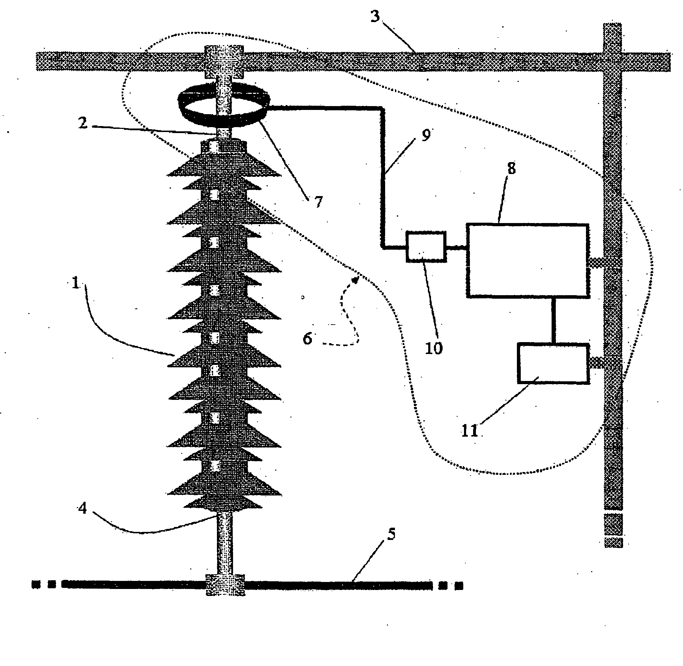

This and other characteristics shall become more readily apparent from the description that follows of a preferred embodiment, illustrated purely by way of non limiting example in the accompanying drawing table, in which the sole figure schematically shows an apparatus according to the present invention, operatively connected to an insulator.

### BEST MODE FOR CARRYING OUT THE INVENTION.

In the figure, the numeral 1 designates an insulator in operating conditions. The insulator 1 defines a low voltage electrode 2, fastened to a support element 3, such as a trestle, and a high voltage electrode 4, fastened to a medium / high voltage conductor 5, constituting an electrical energy transmission line.

The numeral 6 designates a diagnostic apparatus for evaluating the level of superficial pollution of the insulator 1, according to the present invention. The apparatus 6 comprises a sensor 7, able to be associated to the insulator 1 to detect an electrical signal. In a preferred embodiment (shown in the figure), the sensor 7 is constituted by a current transformer for high frequencies (known in itself) and it is inserted at the low voltage electrode 2. It should be noted that said sensor 7 can advantageously be inserted / removed by an operator during the operation of the insulator 1.

The apparatus 6 further comprises acquisition means 8, connected to the sensor 7 by means of a connecting element, constituted, in the illustrated embodiment, by a cable 9. Said acquisition means 8 are able to receive, through said connecting element, an electrical signal comprising a set of data relating to partial discharges taking place on an outer surface of the insulator 1. The apparatus 6 is also provided with means 10 for conditioning said electrical signal to derive high frequency pulses relating to the partial discharge activity; said conditioning means 10 comprise, in particular, filters and amplifiers of various natures.

It should be noted that, as is well known, the measurement of partial discharges is absolutely non destructive and non invasive with respect to the electrical apparatus whereon they are applied.

It should be noted that, in addition to the sensor 7, able in particular to detect signals relating to an activity of partial discharges, the apparatus 6 comprises additional sensors (not shown because they are substantially known) to acquire and monitor quantities correlated to environmental factors relating to an environment adjacent to the insulator, such as temperature and humidity, and quantities relating to the electrical state of the insulator, such as leakage current. Said quantities undergo relatively slow variations over time, with respect to partial discharge signals; therefore, the apparatus 6 is provided with (known) acquisition channels specifically dedicated to said quantities, which are called "slow channels".

Moreover, the Apparatus 6 comprises means for processing the acquired data, staid processing providing an indicator of the level of superficial pollution of the insulator.

Said processing means can be integrated, together with the acquisition means 8, in a single container, associated to the support 3, substantially at the insulator 1 to be evaluated. Alternatively, the processing means can be installed in any computer, able to receive the data from the acquisition means 8, according to known data transmission techniques. In this regard, it should be stated that the apparatus 6 comprises means for storing the acquired data (e.g., memory banks) and for transmitting input / out data (with or without the use of cables), with the possibility of placing the apparatus 6 in communication with various external storage or display or processing units; said means not being illustrated because they are known.

Moreover, the apparatus 6 comprises means (not shown because they are substantially known) for deriving an electrical synchronisation signal, proportional to the voltage across the ends of the insulators, provided as an input to the acquisition means; said means for deriving an electrical synchronisation signal comprise, in a preferred but not exclusive embodiment, means for measuring the displacement current created by the variations in potential of the high voltage electrode, to derive an electrical signal that is proportional to the voltage across the ends of the insulator. This system is constituted, for example, by an electrical field sensor.

In the illustrated embodiment, the apparatus 6 further comprises, originally, a photovoltaic cell 11 for supplying power to the apparatus itself. Said photovoltaic cell 11 advantageously enables to use the apparatus 6 to monitor any insulator in operation. The apparatus 6 enables to detect, through the acquisition means 8, and to store wave forms relating to pulses of partial discharges. The possibility of having available information pertaining to the whole wave form of each detected discharge pulse provides considerable advantages. In particular, the processing means are able to perform an analysis of the wave forms of said pulses, to group together pulses having substantially similar wave forms in corresponding subsystems of homogeneous data. This enables, advantageously, to evaluate the signals relating to the activity of the partial discharges that take place on the outer surface of the insulator, separately relative to other signals, relating, for example, to additional discharge activities or to external interference. In this way, it is possible to derive, originally, one or more indicators significantly correlated to the level of superficial pollution of the insulator 1, being evaluated on the basis of a set of homogeneous data relating to partial discharges taking place on the outer surface of the insulator. To derive one or more indicators of the level of superficial pollution of the insulator 1, starting from the data acquired relatively to the activity of partial discharges on the outer surface of the insulator, the processing means apply, in a preferred embodiment, artificial intelligence and/or statistical analysis tools, in particular to said subsets of homogeneous data.

Therefore, the described apparatus 6 originally enables to evaluate the level of superficial pollution of a medium / high voltage outdoor insulator, by the acquisition and subsequent processing of signals of partial discharges taking place on the outer surface of the insulator. Said apparatus 6 can advantageously be installed on any outdoor insulator, also while it is operating. The processing of signals, of partial discharges taking place on the outer surface of the insulator originally enables to derive one or more indicators of the level of superficial pollution of the insulator, said indicators being significantly correlated to the criticality of said pollution, with reference to the likelihood of failure. The activity of the partial discharges, on whose evaluation said indicators are based, constitutes a direct cause of failure.

The apparatus 6 may also comprise additional means for acquiring one or more quantities correlated to environment factors (e.g. temperature and humidity), said quantities being then evaluated by the processing means in synergetic fashion together with said set of data relating to the activity of partial discharges.

The present invention also makes available a method for evaluating the level of superficial pollution of a medium/high voltage outdoor insulator 1.

This method originally comprises a step of measuring an activity of partial discharges on an outer surface of the insulator 1. In particular, said measuring step comprises an acquisition of a plurality of electrical signals relating to the activity of partial discharges, constituting a set of data.

The acquisition step provides for the use of a sensor 7, of the type suitable for the transduction of high frequency signals, applied to the insulator 1.

In this way, said acquisition step can advantageously be applied to a sensor 1 during the operation of the insulator itself, and continuously, thereby conducting a monitoring activity on the insulator 1.

Said acquisition of electrical signals relating to the activity of partial discharges preferably entails the acquisition of data relating to the entire wave form of each discharge pulse.

This method also comprises a step of analysing the wave forms of said pulses, to group pulses having substantially similar wave forms in corresponding subsets of homogeneous data. It is thereby possible, advantageously, to analyse signals relating to the partial discharges taking place on the outer surface of the insulator 1, without interference by other discharges or disturbances.

The method also comprises a step of processing said set of data or, preferably, said homogeneous data subset relating to the partial discharges taking place on the outer surface of the insulator 1, to derive an indicator of the level of superficial pollution of the insulator 1. This processing step is preferably conducted automatically, through processing means installed on an electronic calculator / computer.

Therefore, the method described herein originally enables to derive an indicator of the level of superficial pollution of the insulator 1 analysing, substantially, only the signals relating to the activity of the partial discharges taking place on the outer surface of the insulator itself.

In particular, the processing step comprises the application, to said set or subset of data, of statistical processing and / or artificial intelligence techniques, and / or the application of a fuzzy interference engine. Said techniques, which are substantially known in themselves, are applied originally to the determination of one or more indicators of the level of superficial pollution of the insulator 1, possibly on the basis of the results collected in the course of previous measurements conducted on the same insulator or on insulators of the same constructive type, in operation or in a laboratory, in controller environment and under reference conditions.

In this light, the method of the invention comprises a step of comparing an acquired value of a quantity, correlated to the measured activity of partial discharges, with a reference value for the same quantity. This quantity can be constituted, for example, by the average amplitude of the acquired discharges. Said reference value is a value previously measured on a sample insulator having a critical level of superficial pollution; said sample insulator being, preferably, of the same constructive type of the insulator 1 under evaluation. It should be noted that said critical level of superficial pollution is evaluated (experimentally and/or by means of models or simulations) on the basis of the probability of failure of the insulator.

Moreover, the method comprises an additional step of comparing the acquired value and the reference value of said quantity with a second reference value of the same quantity, previously measured on the insulator 1 under evaluation in conditions of minimal value of superficial pollution, and with a third reference value of the same quantity, previously measured on the sample insulator under conditions of maximum value of superficial pollution. In this way, it is possible to obtain a first relative quantity, calculating the ratio between the quantity measured on the insulator 1 under evaluation (in operation) and a corresponding value obtained on the same insulator 1 or on a similar (also in operation) under known conditions of minimum pollution; this presupposes, for example, to perform a measurement on said insulator after cleaning it. Similarly, it is possible to obtain a second relative quantity, calculating the ratio between the value measured on the sample insulator under known conditions of maximum pollution and a corresponding value obtained on the same sample insulator under known condition of minimum pollution. By operating a comparison between said first relative quantity and said second relative quantity, the method of the invention originally enables to derive an indicator of the level of superficial pollution of the insulator 1 that is particular robust, because it takes into account the different conditions in which it is in operation with respect to an insulator in a laboratory.

It should be noted that said comparisons can advantageously be conducted combining a plurality of quantities characterising said activity of partial discharges.

Moreover, the method of the invention comprises a possible step of acquiring quantities correlated to one or more environmental factors (relating an environment that is substantially adjacent to the insulator 1) and / or correlated to the electrical state of the insulator, such as temperature, humidity or leakage current.

It should be noted that both the step of measuring the activity of partial discharges, and the step of acquiring said quantities relating to environment factors and / or correlated to the electrical state can advantageously be conducted continuously, constituting a monitoring of the insulator under evaluation.

The step of acquiring said quantities relating to environmental factors or to the electrical state of the insulator enables, originally, to compare / synergistically combine data directly linked to the causes of pollution, constituted by environmental factors, with data directly linked to the effects of pollution, constituted by the activity of partial discharges. This comparison / combination originally allows a particular robust and significant evaluation of the level of superficial pollution of the insulator. Moreover, said comparison / combination can advantageously be conducted automatically, thanks to the use of said artificial intelligence techniques in the processing step. Therefore, the method of the present invention enables to evaluate the level of superficial pollution of an insulator 1, by means of a non destructive technique, applicable to operating insulators and simple to execute, because it is substantially automatic.

Moreover, the method of the present invention enables to carry out a continuous monitoring of an outdoor insulator 1 in operation, taking into account also the environmental factors associated to the formation of the superficial pollution on the outer surface of the insulator itself.

It should be noted that the diagnostic apparatus and the diagnostic method of the invention advantageously enable to optimise the resources invested in planning maintenance interventions on the insulators, making possible timely and selective interventions on the insulators, based on the actual probability of failure of the insulators themselves.

## Claims

1. Method for evaluating the level of superficial pollution of a medium/high voltage outdoor insulator (1),
**characterised in that** it comprises:
- a step of measuring an activity of partial discharges on an outer surface of the insulator (1), to derive an indicator of the level of superficial pollution of the insulator, said measuring step comprising an acquisition of a plurality of electrical signals relating to the activity of partial discharges, constituting a set of data,
- a step of automatically processing said set of data, in order to automatically derive said indicator, wherein said processing step comprises a statistical analysis of said set of data.

2. Method as claimed in claim 1, wherein said electrical signals comprise wave forms of pulses of partial discharges.

3. Method as claimed in claim 2, **characterised in that** it comprises a step of analysing the wave forms of said pulses, to group pulses having substantially similar wave forms in corresponding subsets of homogeneous data.

4. Method as claimed in claim 1, wherein said processing is conducted on a subset of homogeneous data.

5. Method as claimed in any of the previous claims, **characterised in that** it comprises a step of comparing an acquired value of a quantity, correlated to the measured activity of partial discharges, with a reference value for the same quantity.

6. Method as claimed in claim 5, wherein said reference value is a value that was previously measured on a sample insulator having a critical level of superficial pollution.

7. Method as claimed in claim 6, wherein said sample insulator has the same constructive type of the insulator (1) being evaluated.

8. Method as claimed in claim 5 or 6 or 7, **characterised in that** it comprises a step of comparing the acquired value and the reference value of said quantity with a second reference value of the same quantity, previously measured on the insulator (1) under evaluation, under conditions of minimum value of superficial pollution, and with a third reference value of the same quantity, previously measured on the sample insulator under conditions of maximum value of superficial pollution.

9. Method as claimed in any of the claims from 6 to 8, **characterised in that** said comparison is carried out on the basis of a plurality of quantities, which may be combined together to derive a statistical indicator.

10. Method as claimed in any of the previous claims, **characterised in that** it comprises a step of acquiring one or more quantities correlated to environmental factors, relating to an environment that is substantially adjacent to the insulator (1) and / or to the electrical state of the insulator (1).

11. Method as claimed in claim 10, **characterised in that** it comprises a step of evaluating and comparing said quantities correlated to environmental factors and / or to the electrical state of the insulator (1) and one or more quantities correlated to the activity of partial discharges.

12. Diagnostic apparatus (6) for evaluating the level of superficial pollution of an outdoor medium / high voltage insulator (1), provided with at least one sensor (7) able to be operatively associated to the insulator (1) to detect an electrical signal, **characterised in that** it comprises, in combination:
- means (8) for acquiring a set of data relating to partial discharges on an outer surface of the insulator (1), said acquisition means receiving said electrical signal at their input, said the acquisition means (8) being able to measure and store wave forms, relating to pulses of partial discharges;
- means for processing the acquired data, said processing providing an indicator of the level of superficial pollution of the insulator (1).

13. Apparatus as claimed in claim 12, **characterised in that** it comprises a photovoltaic cell (11) for supplying power to the apparatus (6) itself.

14. Apparatus as claimed in claim 12, **characterised in that** the processing means are able to conduct an analysis of the wave forms of said pulses, to group pulses having substantially similar wave forms in corresponding subsets of homogeneous data.

15. Apparatus as claimed in any of the claims 12 through 14, **characterised in that** it comprises means for acquiring one or more quantities correlated to environmental factors, relating to an environment that is substantially adjacent to the insulator (1) and / or to the electrical state of the insulator (1).

## Patentansprüche

1. Verfahren zur Evaluierung des Grades oberflächlicher Verunreinigung eines Mittel-/Hochspannungs-Freiluftisolators (1),
**dadurch gekennzeichnet, dass** es Folgendes beinhaltet:
- einen Schritt des Messens einer Teilentladungsaktivität auf einer Außenoberfläche des Isolators (1), um daraus einen Indikator für den Grad der oberflächlichen Verunreinigung des Isolators abzuleiten, wobei dieser Messschritt eine Erfassung mehrerer elektrischer Signale beinhaltet, die auf die Teilentladungsaktivität bezogen sind und einen Datensatz bilden,
- einen Schritt des automatischen Verarbeitens des genannten Datensatzes, um den genannten Indikator automatisch herzuleiten, worin der Verarbeitungsschritt eine statistische Analyse des Datensatzes beinhaltet.

2. Verfahren nach Anspruch 1, worin die genannten elektrischen Signale Wellenformen von Teilentladungsimpulsen beinhalten.

3. Verfahren nach Anspruch 2, **dadurch gekennzeichnet, dass** es einen Schritt des Analysierens der Wellenformen der genannten Impulse beinhaltet, um Impulse mit im Wesentlichen ähnlichen Wellenformen zu entsprechenden Untersätzen homogener Daten zu gruppieren.

4. Verfahren nach Anspruch 1, worin die Verarbeitung an einem Untersatz homogener Daten ausgeführt wird.

5. Verfahren nach einem der vorhergehenden Ansprüche, **dadurch gekennzeichnet, dass** es einen Schritt des Vergleichens eines erfassten Wertes einer mit der gemessenen Teilentladungsaktivität korrelierten Größe mit einem Bezugswert für dieselbe Größe beinhaltet.

6. Verfahren nach Anspruch 5, worin der Bezugswert ein Wert ist, der zuvor auf einem Probeisolator mit einem kritischen Grad oberflächlicher Verunreinigung gemessen wurde.

7. Verfahren nach Anspruch 6, worin der Probeisolator vom selben Konstruktionstyp ist wie der zu evaluierende Isolator (1).

8. Verfahren nach Anspruch 5 oder 6 oder 7, **dadurch gekennzeichnet, dass** es einen Schritt des Vergleichens des erfassten Wertes und des Bezugswertes der genannten Größe mit einem zweiten Bezugswert derselben Größe beinhaltet, der zuvor an dem zu evaluierenden Isolator (1) unter Bedingungen eines minimalen Wertes der oberflächlichen Verunreinigung gemessen wurde, und mit einem dritten Bezugswert derselben Größe, der zuvor an dem Probeisolator unter Bedingungen eines maximalen Wertes der oberflächlichen Verunreinigung gemessen wurde.

9. Verfahren nach einem der Ansprüche von 6 bis 8, **dadurch gekennzeichnet, dass** der genannte Vergleich auf der Basis mehrerer Größen ausgeführt wird, die miteinander kombiniert werden können, um einen statistischen Indikator abzuleiten.

10. Verfahren nach einem der vorhergehenden Ansprüche, **dadurch gekennzeichnet, dass** es einen Schritt des Erfassens von einer oder mehreren Größen beinhaltet, die mit Umgebungsfaktoren, die sich auf eine im Wesentlichen an den Isolator (1) angrenzende Umgebung beziehen, und / oder mit dem elektrischen Status des Isolators (1) korreliert sind.

11. Verfahren nach Anspruch 10, **dadurch gekennzeichnet, dass** es einen Schritt des Evaluierens und Vergleichens der mit den Umgebungsfaktoren und / oder mit dem elektrischen Status des Isolators (1) korrelierten Größen mit einer oder mehreren Größen, die mit der Teilentladungsaktivität korreliert sind, beinhaltet.

12. Diagnosevorrichtung (6) zur Evaluierung des Grades oberflächlicher Verunreinigung eines Mittel-/Hochspannungs-Freiluftisolators (1), die mit mindestens einem Sensor (7) ausgestattet ist, der mit dem Isolator (1) wirkverbunden werden kann, um ein elektrisches Signal zu erfassen,
**dadurch gekennzeichnet, dass** sie, in Kombination, Folgendes beinhaltet:
- Mittel (8) zum Erfassen eines Datensatzes, bezogen auf Teilentladungen auf einer Außenoberfläche des Isolators (1), wobei diese Erfassungsmittel das genannte elektrische Signal an ihrem Eingang empfangen, und wobei die Erfassungsmittel (8) in der Lage sind, auf Teilentladungsimpulse bezogene Wellenformen zu messen und zu speichern;
- Mittel zum Verarbeiten der erfassten Daten, wobei durch diese Verarbeitung ein Indikator für den Grad der oberflächlichen Verunreinigung des Isolators (1) bereitgestellt wird.

13. Vorrichtung nach Anspruch 12, **dadurch gekennzeichnet, dass** sie eine photovoltaische Zelle (11) zur Energieversorgung der Vorrichtung (6) beinhaltet.

14. Vorrichtung nach Anspruch 12, **dadurch gekennzeichnet, dass** die Verarbeitungsmittel in der Lage sind, eine Analyse der Wellenformen der genannten Impulse auszuführen, um Impulse mit im Wesentlichen ähnlichen Wellenformen zu entsprechenden Untersätzen homogener Daten zu gruppieren.

15. Vorrichtung nach einem der Ansprüche 12 bis 14, **dadurch gekennzeichnet, dass** sie Mittel zum Erfassen von einer oder mehreren Größen beinhaltet, die mit Umgebungsfaktoren, die sich auf eine im Wesentlichen an den Isolator (1) angrenzende Umgebung beziehen, und / oder mit dem elektrischen Status des Isolators (1) korreliert sind.

## Revendications

1. Un procédé pour évaluer le niveau de pollution superficielle d'un isolateur (1) extérieur de moyenne ou haute tension,
**caractérisé en ce qu'**il comprend :
- une phase consistant à mesurer une activité de décharges partielles sur une surface extérieure de l'isolateur (1), pour dériver un indicateur du niveau de pollution superficielle de l'isolateur, ladite phase de mesure comprenant une acquisition d'une pluralité de signaux électriques relatifs à l'activité de décharges partielles, constituant un ensemble de données,
- une phase consistant à traiter automatiquement ledit ensemble de données, de manière à dériver automatiquement ledit indicateur, où ladite phase de traitement comprend une analyse statistique dudit ensemble de données.

2. Le procédé selon la revendication 1, **caractérisé en ce que** lesdits signaux électriques comprennent des formes d'onde d'impulsions de décharges partielles.

3. Le procédé selon la revendication 2, **caractérisé en ce qu'**il comprend une phase consistant à analyser les formes d'onde desdites impulsions, pour regrouper les impulsions ayant des formes d'onde essentiellement similaires dans des sous-ensembles correspondants de données homogènes.

4. Le procédé selon la revendication 1, **caractérisé en ce que** ledit traitement est mis en oeuvre sur un sous-ensemble de données homogènes.

5. Le procédé selon l'une quelconque des revendications précédentes, **caractérisé en ce qu'**il comprend une phase consistant à comparer une valeur acquise d'une quantité, corrélée à l'activité mesurée de décharges partielles, avec une valeur de référence pour la même quantité.

6. Le procédé selon la revendication 5, **caractérisé en ce que** ladite valeur de référence est une valeur qui a été précédemment mesurée sur un isolateur échantillon ayant un niveau critique de pollution superficielle.

7. Le procédé selon la revendication 6, **caractérisé en ce que** ledit isolateur échantillon a le même type de construction que l'isolateur (1) en cours d'évaluation.

8. Le procédé selon la revendication 5 ou 6 ou 7, **caractérisé en ce qu'**il comprend une phase consistant à comparer la valeur acquise et la valeur de référence de ladite quantité avec une deuxième valeur de référence de la même quantité, précédemment mesurée sur l'isolateur (1) en cours d'évaluation, dans des conditions de valeur minimum de pollution superficielle, et avec une troisième valeur de référence de la même quantité, précédemment mesurée sur l'isolateur échantillon dans des conditions de valeur maximum de pollution superficielle.

9. Le procédé selon l'une quelconque des revendications de 6 à 8, **caractérisé en ce que** ladite comparaison est effectuée sur la base d'une pluralité de quantités, qui peuvent être combinées ensemble pour dériver un indicateur statistique.

10. Le procédé selon l'une quelconque des revendications précédentes, **caractérisé en ce qu'**il comprend une phase consistant à acquérir une ou plusieurs quantités corrélées à des facteurs ambiants, relatifs à un environnement qui est essentiellement adjacent à l'isolateur (1) et/ou à l'état électrique de l'isolateur (1).

11. Le procédé selon la revendication 10, **caractérisé en ce qu'**il comprend une phase consistant à évaluer et à comparer lesdites quantités corrélées à des facteurs ambiants et/ou à l'état électrique de l'isolateur (1) et une ou plusieurs quantités corrélées à l'activité de décharges partielles.

12. Un appareil (6) de diagnostic pour évaluer le niveau de pollution superficielle d'un isolateur (1) extérieur de moyenne ou haute tension, doté d'au moins un capteur (7) pouvant être opérationnellement associé à l'isolateur (1) pour détecter un signal électrique,
**caractérisé en ce qu'**il comprend, en combinaison :
- des moyens (8) d'acquisition d'un ensemble de données relatives à des décharges partielles sur une surface extérieure de l'isolateur (1), lesdits moyens d'acquisition recevant ledit signal électrique en entrée, lesdits moyens d'acquisition (8) pouvant mesurer et mémoriser des formes d'onde relatives à des impulsions de décharges partielles ;
- des moyens de traitement des données acquises, ledit traitement fournissant un indicateur du niveau de pollution superficielle de l'isolateur (1).

13. L'appareil selon la revendication 12, **caractérisé en ce qu'**il comprend une cellule photovoltaïque (11) pour alimenter l'appareil (6) lui-même.

14. L'appareil selon la revendication 12, **caractérisé en ce que** les moyens de traitement peuvent effectuer une analyse des formes d'onde desdites impulsions, pour regrouper les impulsions ayant des formes d'onde essentiellement similaires dans des sous-ensembles correspondants de données homogènes.

15. L'appareil selon l'une quelconque des revendications de 12 à 14, **caractérisé en ce qu'**il comprend des moyens pour acquérir une ou plusieurs quantités corrélées à des facteurs ambiants, relatifs à un environnement qui est essentiellement adjacent à l'isolateur (1) et/ou à l'état électrique de l'isolateur (1).
